(19) **Europäisches Patentamt / European Patent Office / Office européen des brevets**

(11) **EP 1 585 217 B1**

(12) **FASCICULE DE BREVET EUROPEEN**

(45) Date de publication et mention
de la délivrance du brevet:
**19.09.2007 Bulletin 2007/38**

(51) Int Cl.:
***H03G 3/30*** *(2006.01)*

(21) Numéro de dépôt: **04290939.0**

(22) Date de dépôt: **08.04.2004**

(54) **Procédé de contrôle de la puissance du signal de sortie d'un système amplificateur, et système associé**

Verfahren zur Regelung der Leistung des Ausgangssignals eines Verstärkersystems, und entsprechendes System

Process of controlling the power of the output signal of an amplifier system, and associated system

(84) Etats contractants désignés:
**DE FR GB IT**

(43) Date de publication de la demande:
**12.10.2005 Bulletin 2005/41**

(73) Titulaire: **STMicroelectronics N.V.**
**1118 BH Schiphol Airport Amsterdam (NL)**

(72) Inventeurs:
• **Cerisier, Patrick**
**74350 Copponex (FR)**
• **Musy, Patrice**
**1212 Grand-Lancy-Geneve (CH)**

(74) Mandataire: **Zapalowicz, Francis**
**Bureau Casalonga & Josse**
**Bayerstrasse 71/73**
**80335 München (DE)**

(56) Documents cités:
**EP-A- 0 813 294        EP-A- 0 889 583**
**DE-A- 10 100 151        US-A- 5 732 334**

## Description

L'invention concerne d'une façon générale le contrôle de puissance du signal de sortie d'un dispositif amplificateur, et elle s'applique avantageusement, mais non limitativement aux architectures émettrices radiofréquences des systèmes de communication sans fil, notamment les systèmes CDMA ou WCDMA, pour contrôler la puissance de sortie au niveau du connecteur d'antenne.

Des systèmes pour contrôler la puissance de sortie d'un amplificateur sont connus de EP-A-0813294, DE-A-10100151, US-A-5 732 334 ou EP-A-0 889 583.

Les systèmes CDMA (Système à accès multiples par division de code; "Code Division Multiple Access" en langue anglaise) permettent aux utilisateurs multiples de partager une fréquence commune et un canal temporel commun en utilisant une modulation codée. Parmi les systèmes CDMA on peut citer le système CDMA 2000, le système WCDMA ("Wide Band CDMA" en langue anglaise; CDMA large bande) ou la norme IS-95.

Dans les systèmes CDMA, on peut encore distinguer ceux qui utilisent une fréquence distincte pour l'émission et la réception (système CDMA-FDD) et ceux qui utilisent une fréquence commune pour l'émission et la réception, mais des domaines temporels distincts pour l'émission et la réception (système CDMA-TDD).

A l'opposé des systèmes de communication ayant une modulation à enveloppe constante, comme le système GSM, les systèmes CDMA utilisent un signal modulé qui a une modulation à enveloppe non constante. En d'autres termes, un tel signal est modulé en phase et en amplitude, et l'amplitude de la modulation n'est pas constante.

Dans les terminaux distants, comme les téléphones mobiles cellulaires, l'étage amplificateur de puissance pour l'émission doit avoir une large plage de fonctionnement de puissance radiofréquence. Et, notamment dans les systèmes CDMA-FDD, l'amplificateur de puissance est continuellement en fonctionnement pendant les communications.

Plus précisément, la puissance d'émission délivrée par l'amplificateur de puissance, peut varier dans une plage de puissances prédéterminée, typiquement de -50 dBm à 24 dBm par pas de 1dB pour les téléphones mobiles de troisième génération. Dans cette plage de puissance, la puissance d'émission est ajustée en fonction d'informations de puissance régulièrement reçues par le téléphone et en provenance de la station de base.

En outre, à chaque demande de modification de la puissance d'émission par une station de base, cette modification doit être effectuée en un délai court, typiquement de 50 μs.

Or, pour vérifier la puissance d'émission, il faut la détecter en sortie du système, et lorsque le signal est à enveloppe non constante, le signal de sortie du détecteur comporte des ondulations ("ripple" en langue anglaise) qui peuvent être très importantes et se situer dans une plage de fréquences de 0 à 4 MHz dans les systèmes W-CDMA. Il est alors nécessaire de filtrer ce signal de sortie. Mais ce filtrage nécessite une constante de temps très grande ce qui est incompatible avec le délai d'établissement de la puissance d'émission demandée.

L'invention vise à apporter une solution à ce problème, et propose une solution radicalement différente pour le contrôle de la puissance de sortie d'un montage amplificateur, tout particulièrement lorsque le signal de sortie est, après détection, entaché d'ondulations comme dans le cas des signaux modulés à enveloppe non constante.

Le but de l'invention est de contrôler la puissance d'émission d'un terminal distant en particulier un téléphone mobile cellulaire, en filtrant un signal représentatif de la puissance de sortie, sans qu'il y ait incompatibilité entre le temps de filtrage, et le temps d'établissement d'une nouvelle puissance d'émission demandée.

L'invention propose donc un procédé de régulation de puissance du signal de sortie d'un système comprenant au moins un amplificateur initial à gain variable recevant un signal incident. On élabore une information numérique filtrée représentative de la puissance du signal de sortie. On élabore une information de commande à partir d'une consigne représentative d'une puissance souhaitée pour le signal de sortie, et d'un modèle à suivre ayant une fonction de transfert souhaitée pour l'établissement de ladite puissance en un temps de réponse souhaité. De plus, on élabore une commande de gain et une commande de courant de polarisation pour chaque amplificateur initial à gain variable, à partir de l'information numérique filtrée, de l'information de commande, et d'une régulation numérique polynomiale de type RST dont les coefficients des polynômes sont déterminés à partir de paramètres d'entrée comportant des caractéristiques de chaque amplificateur à gain variable et de caractéristiques du filtre d'élaboration de ladite information numérique filtrée.

Avantageusement, le signal incident est un signal modulé avec une modulation à enveloppe non constante.

Selon l'invention, la régulation RST permet, en effectuant un préfiltrage, de décorréler la constante de temps du filtre de détection du temps d'établissement (par exemple 50μs) de la puissance demandée.

Dans un mode de mise en oeuvre préféré, le système comprenant en outre un amplificateur de sortie à gain variable, connecté en sortie du dernier amplificateur initial à gain variable, on élabore, en outre, à partir de ladite consigne et sans passer par ladite régulation numérique polynomiale de type RST, une commande de gain et une commande de courant de polarisation pour l'amplificateur de sortie à gain variable.

Avantageusement, lorsque le système comprend au moins un moyen de transposition de fréquence on élabore en outre une commande de courant de polarisation et éventuellement une commande de gain pour chaque moyen de transposition de fréquence.

Le modèle à suivre est, par exemple, un filtre ayant une fonction de transfert choisie.

Dans un mode de mise en oeuvre préféré, lesdits paramètres d'entrée comprennent les temps de réponse et les ordres des fonctions de transfert de chaque amplificateur à gain variable, la constante de temps du filtre d'élaboration de ladite information numérique filtrée, et une bande de fréquence à rejeter.

De manière avantageuse, l'on élabore ladite commande de gain et ladite commande de courant de polarisation de chaque amplificateur initial à gain variable à partir d'une valeur de signal de sortie de ladite régulation numérique polynomiale de type et d'au moins une table de correspondance.

Selon l'invention, il est également proposé un système amplificateur avec régulation de puissance du signal de sortie, comprenant au moins un amplificateur initial à gain variable et recevant un signal incident. Le système comprend :

- des premiers moyens d'élaboration pour élaborer une information numérique filtrée représentative de la puissance du signal de sortie ;
- un modèle à suivre recevant une consigne représentative d'une puissance souhaitée pour le signal de sortie, ayant une fonction de transfert souhaitée pour l'établissement de ladite puissance en un temps de réponse souhaité, et délivrant une information de commande ; et
- des moyens de commande comprenant un régulateur numérique polynomial de type RST, ces moyens de commande étant aptes à élaborer une commande de gain et une commande de courant de polarisation pour chaque amplificateur initial à gain variable, à partir de l'information numérique filtrée et de l'information de commande, les coefficients des polynômes du régulateur dépendant de paramètres d'entrée comportant des caractéristiques de chaque amplificateur à gain variable et de caractéristiques du filtre des premiers moyens d'élaboration.

Avantageusement, le signal incident est un signal modulé avec une modulation à enveloppe variable.

Dans un mode de réalisation préféré, le régulateur numérique polynomial de type RST comprend trois filtres numériques à réponse impulsionnelle finie, un filtre R recevant l'information numérique filtrée, un filtre T recevant l'information de commande, et le filtre 1/S délivrant un signal de sortie.

Dans un mode de réalisation avantageux, le système comprend, en outre, un amplificateur de sortie à gain variable, connecté en sortie du dernier amplificateur initial à gain variable, une alimentation à découpage et un convertisseur numérique/analogique, aptes à élaborer une commande de gain et une commande de courant de polarisation pour l'amplificateur de sortie à gain variable à partir de ladite consigne sans passer par ledit régulateur numérique polynomial de type RST.

Les premiers moyens d'élaboration comprennent, par exemple :

- des moyens de prélèvement d'une image de la tension électrique de sortie dudit système ;
- un filtre (DET) connecté en aval des moyens de prélèvement ; et
- des moyens de conversion analogique/numérique (A/N) connectés en aval du filtre et délivrant l'information numérique filtrée.

Avantageusement, le système comprend en outre au moins un moyen de transposition de fréquence, lesdits moyens de commande étant aptes à élaborer une commande de courant de polarisation et éventuellement une commande de gain pour chaque moyen de transposition de fréquence.

En outre, les moyens de commande comprennent au moins une table de correspondance pour déterminer les commandes de gain et les commandes de courant de polarisation à partir du signal de sortie du régulateur numérique polynomial de type RST.

Selon l'invention, il est également proposé un élément de communication sans fil, par exemple un téléphone mobile cellulaire, comprenant une chaîne d'émission incorporant un système tel que décrit précédemment.

D'autres avantages et caractéristiques de l'invention apparaîtront à l'examen de la description détaillée de modes de mise en oeuvre et de réalisation, nullement limitatifs, et des dessins annexés, sur lesquels :

- la figure 1 illustre un mode de réalisation d'un système selon l'invention ;
- la figure 2 illustre un signal modulé avec une modulation à enveloppe variable ;
- la figure 3 illustre une information numérique filtrée représentative du signal de sortie ;
- la figure 4 illustre un autre mode de réalisation d'un système selon l'invention ; et
- les figures 5 et 6 illustrent une application de l'invention à un téléphone mobile cellulaire.

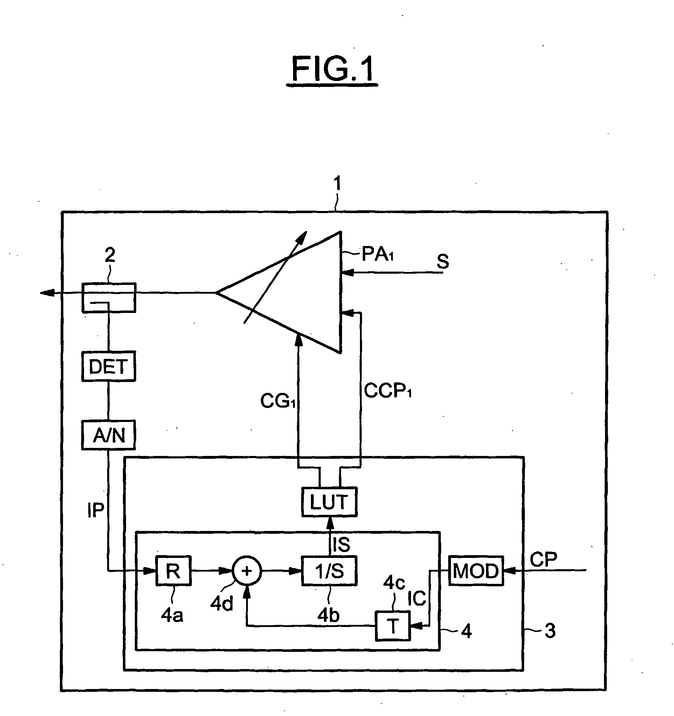

La figure 1 représente un système 1 comprenant un amplificateur à gain variable $PA_1$ recevant en entrée un signal incident S. En sortie de l'amplificateur à gain variable $PA_1$, un élément 2 de prélèvement, tel un coupleur directif, permet de prélever un signal représentatif de la puissance de sortie de l'amplificateur à gain variable $PA_1$, c'est-à-dire de prélever une image de la tension électrique de sortie du système 1.

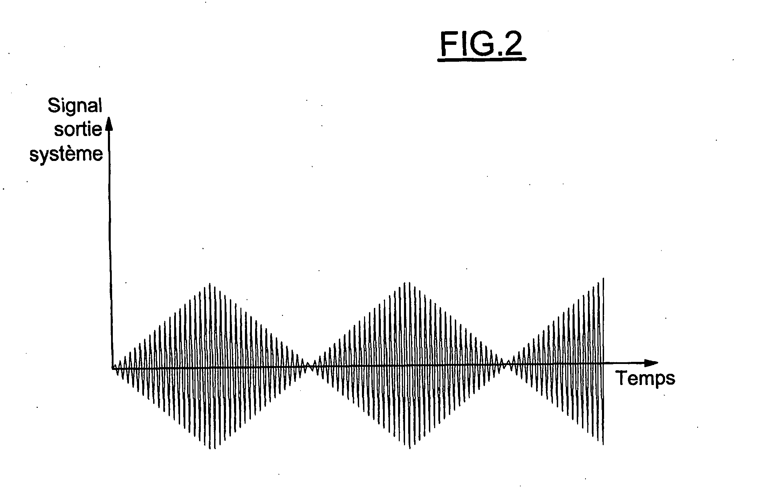

Par exemple, on prélève la tension électrique de sortie de l'amplificateur à gain variable $PA_1$, diminuée de vingt décibels, avec connaissance de l'impédance de l'élément de prélèvement, ce qui permet de connaître la puissance correspondante. La tension prélevée étant diminuée de vingt décibels, elle est cent fois plus petite que la tension de sortie, et permet de ne pas altérer le signal de sortie de l'amplificateur à gain variable $PA_1$. Le signal prélevé a une allure représentée sur la figure 2 lorsqu'il est issu d'un signal incident modulé en phase et en amplitude (modulation à enveloppe variable).

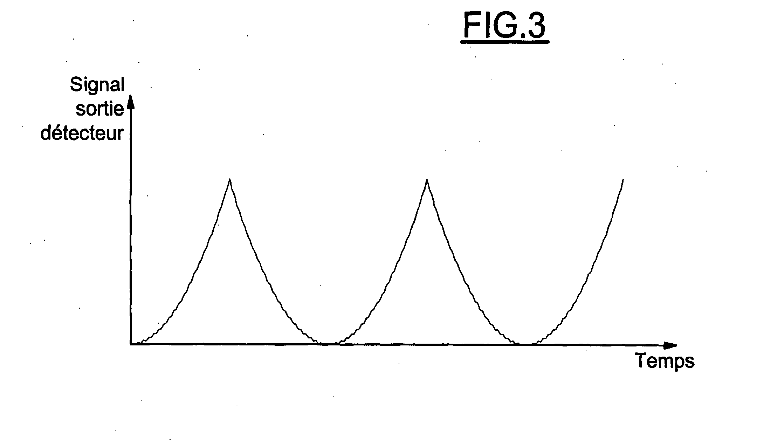

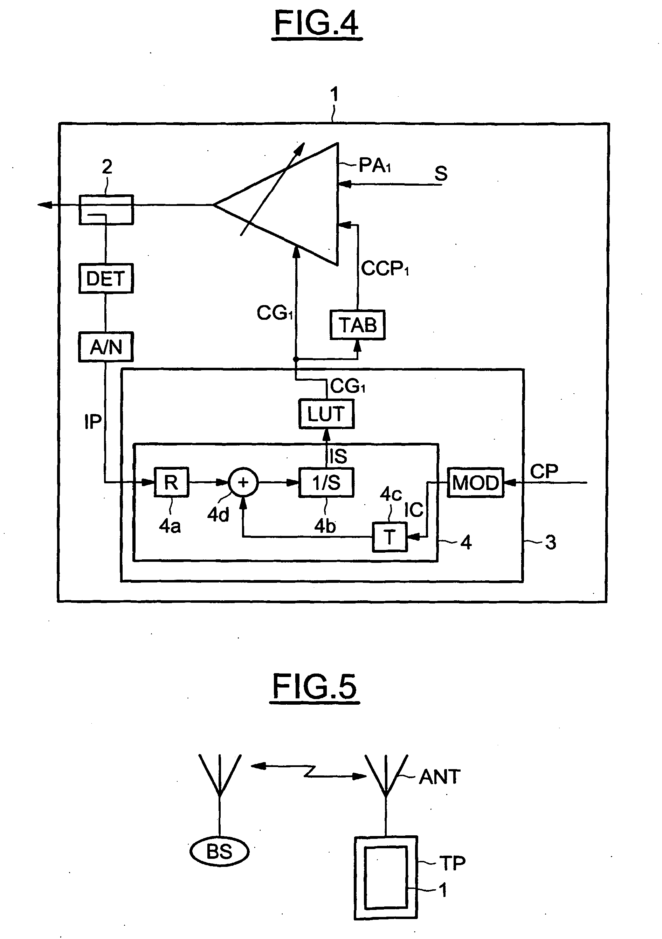

Le signal prélevé arrive en entrée d'un filtre DET qui délivre en sortie l'enveloppe, ou l'enveloppe élevée à la puissance deux du signal prélevé, comme représenté sur la figure 3. Dans l'exemple traité, le filtre DET délivre l'enveloppe du signal prélevé élevée à la puissance deux, représenté sur la figure 4. Comme on peut le voir sur la figure 4, le filtre DET ne récupère le carré de l'enveloppe du signal prélevé qu'avec une précision limitée, car il subsiste de petites oscillations dues au signal originel. L'élimination de ces oscillations nécessite normalement un filtrage additionnel ayant une constante de temps grande qui peut s'avérer incompatible dans certaines applications comme les applications W-CDMA, avec un temps d'établissement court pour la puissance de sortie demandée.

L'invention résout ce problème d'incompatibilité en décorrélant, par l'utilisation en particulier d'une régulation numérique de type RST, le délai de filtrage nécessaire au signal de sortie du filtre DET, et le délai maximum d'établissement d'une nouvelle puissance de sortie de l'amplificateur à gain variable $PA_1$.

Plus précisément, le signal de sortie du filtre DET est numérisé au moyen d'un convertisseur analogique/numérique A/N. On obtient alors une information numérique IP représentative de la puissance de sortie de l'amplificateur à gain variable $PA_1$. Cette information numérique IP est délivrée en entrée d'un régulateur numérique polynomial de type RST 4 incorporé dans un module de commande 3. Le régulateur 4 reçoit également en entrée une consigne numérique CP représentative de la puissance souhaitée du signal de sortie de l'étage d'amplification à gain variable $PA_1$. Le module de commande 3 comprend en outre un modèle à suivre MOD, qui est par exemple un filtre, ayant une fonction de transfert prédéterminée souhaitée correspondant à une évolution souhaitée pour l'établissement de la nouvelle puissance, et une constante de temps correspondant à la durée d'établissement souhaitée pour la puissance (par exemple 50 μs).

Un régulateur de type RST est connu de l'homme du métier, et est décrit notamment dans le chapitre 10 du livre intitulé "Commande numérique de systèmes dynamiques", de Roland Longchamps, aux éditions Presses polytechniques et universitaires romandes. On en rappelle ici les caractéristiques principales

Le régulateur de type RST comprend trois filtres numériques à réponse impulsionnelle finie 4a, 4b, 4c ayant des fonctions de transfert respectives R, 1/S et T. Les coefficients des polynômes R, S, T des fonctions de transfert de ces filtres numériques déterminés par un algorithme de synthèse RST de façon à ce qu'en boucle fermée, le régulateur ait pour fonction de transfert celle du modèle à suivre MOD.

La détermination des coefficients des polynômes fait également intervenir des paramètres d'entrée comportant des caractéristiques de l'amplificateur à gain variable $PA_1$, et de caractéristiques du filtre DET d'élaboration de ladite information numérique filtrée IP. Ces caractéristiques comprennent le temps de réponse et l'ordre de la fonction de transfert de l'amplificateur à gain variable $PA_1$, la constante de temps du filtre DET, et une bande de fréquence à rejeter. La bande de fréquences à rejeter correspond aux ondulations du signal en sortie du détecteur.

La consigne numérique CP est filtrée par le modèle à suivre MOD, et le résultat de ce filtrage est une information de commande IC qui est délivrée en entrée du filtre 4c (filtre T).

Le régulateur polynomial de type RST 4 comprend également un module d'addition 4d sommant les sorties des filtres 4a (filtreR) et 4c (filtre T) pour délivrer la somme au filtre 4b (filtre 1/S).

En sortie du filtre 4b (filtre 1/S), un signal numérique de sortie IS est destiné à une table de correspondance LUT qui, à partir de ce signal de sortie IS, fait correspondre une commande de gain $CG_1$ et une commande de courant de polarisation $CCP_1$ pour l'amplificateur à gain variable $PA_1$. Cette table de correspondance tient compte des caractéristiques de l'amplificateur à gain variable $PA_1$.

La figure 4 représente une variante du système représenté sur la figure 1, dans laquelle la table de correspondance LUT ne délivre qu'une commande de gain $CG_1$, et à partir de cette commande de gain $CG_1$, une autre table de correspondance TAB délivre une commande de courant de polarisation $CCP_1$ à l'amplificateur à gain variable $PA_1$.

Sur la figure 5, on a représenté un système 1 selon l'invention, qui est incorporé dans la chaîne d'émission d'un téléphone mobile cellulaire TP, fonctionnant selon la norme W-CDMA, l'invention n'étant bien sûr pas limité à cette application particulière.

Le téléphone dialogue avec une station de base BS par l'intermédiaire d'une antenne ANT. Le système 1 permet d'adapter la puissance du signal d'émission du téléphone mobile cellulaire TP en fonction de la puissance d'émission qui lui est demandée par la station de base BS. La fréquence de ce changement de puissance d'émission est, par exemple, de l'ordre de mille cinq cents fois par seconde.

Pour une fréquence de changement de puissance d'émission de mille cinq cents fois par seconde, il faut modifier la puissance d'émission toutes les six cent soixante-sept microsecondes environ, et dans ce cas, la norme impose un délai pour atteindre la nouvelle puissance d'émission demandée. Par exemple pour la norme 3GPP, ce délai d'établissement d'une nouvelle puissance d'émission est de cinquante microsecondes. Comme expliqué ci avant, la courbe d'évolution et le délai de cet établissement détermine le modèle à suivre MOD, par exemple sous forme de filtre ayant une fonction de transfert choisie et une constante de temps choisie.

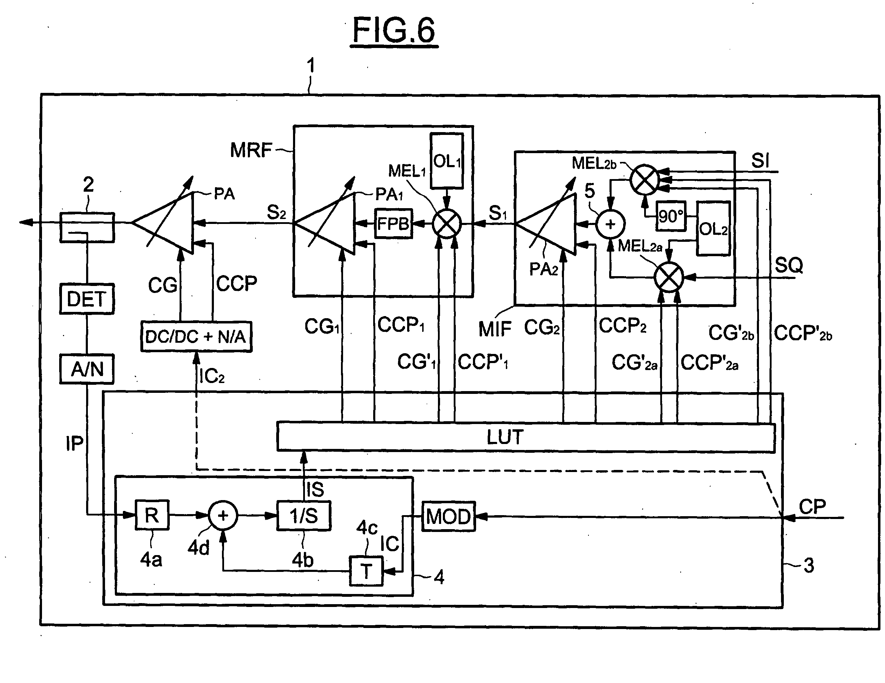

L'architecture de la chaîne d'émission du téléphone incorporant un système 1 selon l'invention est illustré plus en détail sur la figure 6.

On voit sur cette figure que la chaîne d'émission est à architecture superhétérodyne avec un premier étage amplificateur à gain variable MIF à fréquence intermédiaire, par exemple 500MHz, suivi d'un deuxième étage amplificateur à gain variable MRF à fréquence RF (radiofréquences), par exemple 2,6GHz.

Classiquement l'étage MIF comprend deux mélangeurs $MEL_{2b}$ et $MEL_{2a}$ recevant respectivement deux signaux en bande de base SI et SQ, mutuellement déphasés de 90° et émanant du processus en bande de base du téléphone.

Ces deux mélangeurs transposent les signaux SI et SQ à la fréquence intermédiaire à partir de deux signaux de transposition issus d'un oscillateur local $OL_2$.

La somme (additionneur 5) des deux signaux transposés est amplifiée dans un amplificateur à gain variable $PA_2$.

Cet étage MIF permet par exemple un contrôle de gain de 60dB.

Le signal $S_1$ issu de l'étage MIF est transposé dans le domaine radiofréquence par un mélangeur $MEL_1$ recevant un autre signal de transposition issu d'un oscillateur local $OL_1$. Après filtrage dans un filtre passe-bande FPB, le signal est amplifié dans un amplificateur à gain variable $PA_1$.

Cet étage MRF permet par exemple un contrôle de gain de 30dB.

Le signal $S_2$ issu de l'étage MRF est ensuite amplifié dans un amplificateur de sortie PA.

La table de correspondance LUT fait correspondre, à partir du signal de commande de sortie du régulateur 4 de type RST, une commande du gain et/ou une commande du courant de polarisation pour chaque étage d'amplification à gain variable PA1 et PA2, respectivement nommées $CG_1$, $CCP_1$, $CG_2$, et $CCP_2$.

La détermination des coefficients des polynômes fait également intervenir comme paramètres d'entrée, outre ceux relatifs au détecteur DET et à la bande de fréquences à rejeter, les caractéristiques de chaque amplificateur à gain variable $PA_1$, $PA_2$ et PA (temps de réponse et ordres de la fonction de transfert de chaque amplificateur à gain variable $PA_1$, $PA_2$, et PA.

La table de correspondance LUT délivre également en sortie des commandes de courant de polarisation $CCP'_1 CCP'_{2a} CCP'_{2b}$ et une commande de gain $CG'_1$, $CG'_{2a}$, $CG'_{2b}$ pour chaque moyen de transposition de fréquences $MEL_1$, $MEL_{2a}$, $MEL_{2b}$, cela étant, dans certaines applications et/ou selon l'architecture interne des mélangeurs, la délivrance des commandes de gain $CG'_1$, $CG'_{2a}$, $CG'_{2b}$ est optionnelle.

Le système 1 comprend en outre une alimentation à découpage DC/DC et un convertisseur numérique/analogique N/A, dédiés à l'amplificateur de sortie à gain variable PA. L'alimentation à découpage DC/DC et le convertisseur numérique/analogique N/A, délivrent une commande de gain CG et une commande de courant de polarisation CCP à l'amplificateur de sortie à gain variable PA à partir d'une autre information de commande $IC_2$ élaborée à partir de la consigne CP sans passer par le régulateur numérique polynomial de type RST 4.

Les moyens de commande 3 du système peuvent être incorporés au moins en partie dans le processus en bande de base du téléphone, ces moyens étant alors réalisés sous forme logicielle.

En outre, la variante illustrée sur la figure 4 peut également s'appliquer à la figure 6 (utilisation de deux tables de correspondances).

## Revendications

1. Procédé de contrôle de la puissance du signal de sortie d'un système comprenant au moins un amplificateur initial à gain variable ($PA_2$, $PA_1$) recevant un signal incident (S), **caractérisé en ce que** :

   - on élabore une information numérique filtrée (IP) représentative de la puissance du signal de sortie ;
   - on élabore une information de commande (IC) à partir d'une consigne (CP) représentative d'une puissance souhaitée pour le signal de sortie, et d'un modèle à suivre (MOD) ayant une fonction de transfert souhaitée pour l'établissement de ladite puissance en un temps de réponse souhaité ; et
   - on élabore une commande de gain ($CG_1$, $CG_2$) et une commande de courant de polarisation ($CCP_1$, $CCP_2$) pour chaque amplificateur initial à gain variable ($PA_2$, $PA_1$), à partir de l'information numérique filtrée (IP), de l'information de commande (IC), et d'une régulation numérique polynomiale de type RST dont les coefficients des polynômes sont déterminés à partir de paramètres d'entrée comportant des caractéristiques de chaque amplificateur à gain variable ($PA_2$, $PA_1$, PA) et de caractéristiques du filtre d'élaboration de ladite information numérique filtrée (IP).

2. Procédé selon la revendication 1, **caractérisé en ce que** le signal incident est un signal modulé avec une modulation à enveloppe non constante.

3. Procédé selon la revendication 1 ou 2, **caractérisé en ce que**, le système comprenant en outre un amplificateur de sortie à gain variable (PA), connecté en sortie du dernier amplificateur initial à gain variable, on élabore, en outre, à partir de ladite consigne (CP) et sans passer par ladite régulation numérique polynomiale de type RST, une commande de gain (CG) et une commande de courant de polarisation (CCP) pour l'amplificateur de sortie à gain variable (PA).

**4.** Procédé selon l'une quelconque des revendications 1 à 3, **caractérisé en ce que**, le système comprenant au moins un moyen de transposition de fréquences (MEL$_1$, MEL$_{2a}$, MEL$_{2b}$) on élabore en outre une commande de courant de polarisation

$$( CCP_1^{'}, CCP_{2a}^{'}, CCP_{2b}^{'})$$ et éventuellement une commande de gain

$$( CG_1^{'}, CG_{2a}^{'}, CG_{2b}^{'})$$ pour chaque moyen de transposition de fréquences (MEL$_1$, MEL$_{2a}$, MEL$_{2b}$).

**5.** Procédé selon l'une quelconque des revendications 1 à 4, **caractérisé en ce que** ledit modèle à suivre (MOD) est un filtre ayant une fonction de transfert choisie.

**6.** Procédé selon l'une quelconque des revendications 1 à 5, **caractérisé en ce que** lesdits paramètres d'entrée comprennent les temps de réponse et les ordres des fonctions de transfert de chaque amplificateur à gain variable (PA$_2$, PA$_1$, PA), la constante de temps du filtre d'élaboration de ladite information numérique filtrée (IP), et une bande de fréquences à rejeter.

**7.** Procédé selon l'une quelconque des revendication 1 à 6, **caractérisé en ce que** l'on élabore ladite commande de gain (CG$_1$, CG$_2$) et ladite commande de courant de polarisation (CCP$_1$, CCP$_2$) de chaque amplificateur initial à gain variable (PA$_1$, PA$_2$) à partir d'une valeur de signal de sortie (IS) de ladite régulation numérique polynomiale de type et d'au moins une table de correspondance (LUT).

**8.** Système amplificateur avec régulation de puissance du signal de sortie, comprenant au moins un amplificateur initial à gain variable (PA$_2$, PA$_1$) et recevant un signal incident (S), **caractérisé en ce qu**'il comprend :

   - des premiers moyens d'élaboration pour élaborer une information numérique filtrée (IP) représentative de la puissance du signal de sortie ;
   - un modèle à suivre (MOD) recevant une consigne (CP) représentative d'une puissance souhaitée pour le signal de sortie, ayant une fonction de transfert souhaitée pour l'établissement de ladite puissance en un temps de réponse souhaité, et délivrant une information de commande (IC) ; et
   - des moyens de commande (3) comprenant un régulateur numérique polynomial de type RST (4) et aptes à élaborer une commande de gain

(CG$_1$, CG$_2$) et une commande de courant de polarisation (CCP$_1$, CCP$_2$) pour chaque amplificateur initial à gain variable (PA$_2$, PA$_1$), à partir de l'information numérique filtrée (IP) et de l'information de commande (IC), les coefficients des polynômes du régulateur (4) dépendant de paramètres d'entrée comportant des caractéristiques de chaque amplificateur à gain variable (PA$_2$, PA$_1$, PA) et de caractéristiques du filtre des premiers moyens d'élaboration.

**9.** Système selon la revendication 8, **caractérisé en ce que** le signal incident est un signal modulé avec une modulation à enveloppe variable.

**10.** Système selon la revendication 8 ou 9, **caractérisé en ce que** le régulateur numérique polynomial de type RST (4) comprend trois filtres numériques à réponse impulsionnelle finie, un filtre R (4a) recevant l'information numérique filtrée (IP), un filtre T (4c) recevant l'information de commande (IC), et le filtre 1/S (4b) délivrant un signal de sortie (IS).

**11.** Système selon l'une quelconque des revendications 8 à 10, **caractérisé en ce qu**'il comprend, en outre, un amplificateur de sortie à gain variable (PA), connecté en sortie du dernier amplificateur initial à gain variable, une alimentation à découpage (DC/DC) et un convertisseur numérique/analogique (N/A), aptes à élaborer une commande de gain (CG) et une commande de courant de polarisation (CCP) pour l'amplificateur de sortie à gain variable (PA) à partir de ladite consigne (CP) sans passer par ledit régulateur numérique polynomial de type RST (4).

**12.** Système selon l'une quelconque des revendications 8 à 11, **caractérisé en ce que** lesdits premiers moyens d'élaboration comprennent :

   - des moyens de prélèvement (2) d'une image de la tension électrique de sortie dudit système ;
   - un filtre (DET) connecté en aval des moyens de prélèvement (2) ; et
   - des moyens de conversion analogique/numérique (A/N) connectés en aval du filtre et délivrant l'information numérique filtrée (IP).

**13.** Système selon l'une quelconque des revendications 8 à 12, **caractérisé en ce qu**'il comprend, en outre, au moins un moyen de transposition de fréquences (MEL$_1$, MEL$_{2a}$, MEL$_{2b}$), lesdits moyens de commande (3) étant aptes à élaborer une commande de courant de polarisation $( CCP_1^{'}, CCP_{2a}^{'}, CCP_{2b}^{'})$ et éventuellement une commande de gain $( CG_1^{'}, CG_{2a}^{'}, CG_{2b}^{'})$ pour chaque moyen de

transposition de fréquences ($MEL_1$, $MEL_{2a}$, $MEL_{2b}$).

14. Système selon l'une quelconque des revendications 8 à 13, **caractérisé en ce que** ledit modèle à suivre (MOD) est un filtre ayant une fonction de transfert choisie.

15. Système selon l'une quelconque des revendications 8 à 14, **caractérisé en ce que** lesdits paramètres d'entrée comprennent les temps de réponse et les ordres des fonctions de transfert de chaque amplificateur à gain variable ($PA_2$, $PA_1$, PA), la constante de temps du filtre d'élaboration de ladite information numérique filtrée (IP), et une bande de fréquences à rejeter.

16. Système selon l'une quelconque des revendications 8 à 15, **caractérisé en ce que** les moyens de commande comprennent en outre au moins une table de correspondance (LUT) pour déterminer les commandes de gain ($CG_1$, $CG_2$) et les commandes de courant de polarisation ($CCP_1$, $CCP_2$) à partir du signal de sortie (IS) du régulateur numérique polynomial de type RST (4).

17. Elément de communication sans fil, par exemple un téléphone mobile cellulaire, comprenant une chaîne d'émission incorporant un système selon l'une quelconque des revendications 8 à 16.

**Claims**

1. Method for controlling the power of the output signal of a system comprising at least one initial variable-gain amplifier ($PA_2$, $PA_1$) receiving an incident signal (S), **characterized in that**:

   - filtered digital information (IP) that is representative of the power of the output signal is generated;
   - control information (IC) is generated from a setpoint (CP) that is representative of a desired power for the output signal and from a model to be followed (MOD) having a desired transfer function for establishing the said power in a desired response time; and
   - a gain control ($CG_1$, $CG_2$) and a bias current control ($CCP_1$, $CCP_2$) are established for each initial variable-gain amplifier ($PA_2$, $PA_1$) from the filtered digital information (IP), from the control information (IC) and from a polynomial digital regulation of the RST type whose polynomial coefficients are determined from input parameters comprising characteristics of each variable-gain amplifier ($PA_2$, $PA_1$, PA) and from characteristics of the filter generating the said filtered digital information (IP).

2. Method according to Claim 1, **characterized in that** the incident signal is a modulated signal with a modulation having a varying envelope.

3. Method according to either of Claims 1 and 2, **characterized in that**, when the system also comprises a variable-gain output amplifier (PA) connected at the output of the last initial variable-gain amplifier, a gain control (CG) and a bias current control (CCP) for the variable-gain output amplifier (PA) are also established from the said setpoint (CP) and without passing through the said polynomial digital regulation of the RST type.

4. Method according to any one of Claims 1 to 3, **characterized in that**, the system comprising at least one frequency transposition means ($MEL_1$, $MEL_{2a}$, $MEL_{2b}$), a bias current control

   $$\left( CCP_1', CCP_{2a}', CCP_{2b}' \right)$$ and, where required, a gain control $$\left( CG_1', CG_{2a}', CG_{2b}' \right)$$ is also established for each frequency transposition means ($MEL_1$, $MEL_{2a}$, $MEL_{2b}$).

5. Method according to any one of Claims 1 to 4, **characterized in that** the said model to be followed (MOD) is a filter having a chosen transfer function.

6. Method according to any one of Claims 1 to 5, **characterized in that** the said input parameters comprise the response times and the orders of the transfer functions for each variable-gain amplifier ($PA_2$, $PA_1$, PA), the time constant of the filter generating the said filtered digital information (IP) and a frequency band to be rejected.

7. Method according to any one of Claims 1 to 6, **characterized in that** the said gain control ($CG_1$, $CG_2$) and the said bias current control ($CCP_1$, $CCP_2$) for each initial variable-gain amplifier ($PA_1$, $PA_2$) are established from an output signal value (IS) of the said polynomial digital regulation of the RST type and from at least one correspondence table (LUT).

8. Amplifying system with power regulation of the output signal, comprising at least one initial variable-gain amplifier ($PA_2$, $PA_1$) and receiving an incident signal (S), **characterized in that** it comprises:

   - first generation means for generating filtered digital information (IP) that is representative of the power of the output signal;
   - a model to be followed (MOD) receiving a setpoint (CP) that is representative of a desired power for the output signal, having a desired

7

transfer function for establishing the said power in a desired response time, and delivering control information (IC); and

- control means (3) comprising a polynomial digital regulator of the RST type (4) and capable of establishing a gain control ($CG_1$, $CG_2$) and a bias current control ($CCP_1$, $CCP_2$) for each initial variable-gain amplifier ($PA_2$, $PA_1$), from the filtered digital information (IP) and from the control information (IC), the polynomial coefficients of the regulator (4) depending on input parameters comprising characteristics of each variable-gain amplifier ($PA_2$, $PA_1$, PA) and on characteristics of the filter of the first generation means.

9. System according to Claim 8, **characterized in that** the incident signal is a modulated signal with a variable-envelope modulation.

10. System according to either of Claims 8 and 9, **characterized in that** the polynomial digital regulator of the RST type (4) comprises three digital filters with finite pulse response, one filter R (4a) receiving the filtered digital information (IP), one filter T (4c) receiving the control information (IC) and the filter 1/S (4b) delivering an output signal (IS).

11. System according to any one of Claims 8 to 10, **characterized in that** it additionally comprises a variable-gain output amplifier (PA) connected at the output of the last initial variable-gain amplifier, a switch-mode power supply (DC/DC) and a digital-to-analogue converter (N/A) that are capable of establishing a gain control (CG) and a bias current control (CCP) for the variable-gain output amplifier (PA) from the said setpoint (CP) without passing through the said polynomial digital regulator of the RST type (4).

12. System according to any one of Claims 8 to 11, **characterized in that** the said first generation means comprise:

- means (2) for sampling an image of the output electrical voltage of the said system;
- a filter (DET) connected downstream of the sampling means (2); and
- analogue-to-digital conversion means (A/N) connected downstream of the filter and delivering the filtered digital information (IP).

13. System according to any one of Claims 8 to 12, **characterized in that** it also comprises at least one frequency transposition means ($MEL_1$, $MEL_{2a}$, $MEL_{2b}$), the said control means (3) being capable of establishing a bias current control

$$\left( CCP_1^{'}, CCP_{2a}^{'}, CCP_{2b}^{'} \right)$$ and, where required, a gain control $\left( CG_1^{'}, CG_{2a}^{'}, CG_{2b}^{'} \right)$ for each frequency transposition means ($MEL_1$, $MEL_{2a}$, $MEL_{2b}$).

14. System according to any one of Claims 8 to 13, **characterized in that** the said model to be followed (MOD) is a filter having a chosen transfer function.

15. System according to any one of Claims 8 to 14, **characterized in that** the said input parameters comprise the response times and the orders of the transfer functions for each variable-gain amplifier ($PA_2$, $PA_1$, PA), the time constant of the filter generating the said filtered digital information (IP) and a frequency band to be rejected.

16. System according to any one of Claims 8 to 15, **characterized in that** the control means additionally comprise at least one correspondence table (LUT) for determining the gain controls ($CG_1$, $CG_2$) and the bias current controls ($CCP_1$, $CCP_2$) from the output signal (IS) of the polynomial digital regulator of the RST type (4).

17. Wireless communication element, for example a cellular mobile telephone, comprising a transmission circuit incorporating a system according to any one of Claims 8 to 16.

**Patentansprüche**

1. Verfahren zur Regelung der Leistung des Ausgangssignals eines Systems, das mindestens einen einstellbaren Anfangsverstärker ($PA_2$, $PA_1$) aufweist, der ein eintreffendes Signal (S) empfängt, **dadurch gekennzeichnet, daß**

- eine gefilterte digitale Information (IP) ausgearbeitet wird, die die Leistung des Ausgangssignals repräsentiert;
- aus einem Sollwert (CP), der eine gewünschte Leistung für das Ausgangssignal repräsentiert, und aus einem zu folgenden Modell (MOD), das eine gewünschte Übertragungsfunktion für den Aufbau der Leistung in einer gewünschten Antwortzeit hat, eine Steuerinformation (IC) ausgearbeitet wird; und
- aus der gefilterten digitalen Information (IP), der Steuerinformation (IC) und einer polynomischen digitalen Regelung des Typs RST, deren Polynomkoeffizienten aus Eingangsparametern bestimmt werden, die Kenndaten jedes einstellbaren Verstärkers ($PA_2$, $PA_1$, PA) und Kenndaten des Ausarbeitungsfilters der gefilterten digitalen Information (IP) aufweisen, ein Verstärkungsfaktor-Steuerbefehl ($CG_1$, $CG_2$) und

ein Polarisationsstrom-Steuerbefehl (CCP$_1$, CCP$_2$) für jeden einstellbaren Anfangsverstärker ausgearbeitet werden.

2. Verfahren nach Anspruch 1, **dadurch gekennzeichnet, daß** das eintreffende Signal ein Signal ist, das mit einer Modulation mit einer nicht konstanten Einhüllenden moduliert ist.

3. Verfahren nach Anspruch 1 oder 2, **dadurch gekennzeichnet, daß** - wobei das System ferner einen einstellbaren Ausgangsverstärker (PA) aufweist, der am Ausgang des letzten einstellbaren Anfangsverstärkers angeschlossen ist - aus dem Sollwert (CP) und ohne Durchlauf durch die polynomische digitale Regelung des Typs RST ferner ein Verstärkungsfaktor-Steuerbefehl (CG) und ein Polarisationsstrom-Steuerbefehl (CCP) für den einstellbaren Ausgangsverstärker (PA) ausgearbeitet werden.

4. Verfahren nach einem der Ansprüche 1 bis 3, **dadurch gekennzeichnet, daß** - wobei das System mindestens eine Frequenzumsetzungseinrichtung (MEL$_1$, MEL$_{2a}$, MEL$_{2b}$) aufweist - ferner ein Polarisationsstrom-Steuerbefehl (CCP'$_1$, CCP'$_{2a}$, CCP'$_{2b}$) und gegebenenfalls ein Verstärkungsfaktor-Steuerbefehl (CG'$_1$, CG'$_{2a}$, CG'$_{2b}$) für jede Frequenzumsetzungseinrichtung (MEL$_1$, MEL$_{2a}$, MEL$_{2b}$) ausgearbeitet werden.

5. Verfahren nach einem der Ansprüche 1 bis 4, **dadurch gekennzeichnet, daß** das zu folgende Modell (MOD) ein Filter mit einer gewählten Übertragungsfunktion ist.

6. Verfahren nach einem der Ansprüche 1 bis 5, **dadurch gekennzeichnet, daß** die Eingangsparameter die Antwortzeiten und die Ordnungen der Übertragungsfunktionen jedes einstellbaren Verstärkers (PA$_2$, PA$_1$, PA), die Zeitkonstante des Ausarbeitungsfilters (IP) der gefilterten digitalen Information (IP) und ein Band von zurückzuweisenden Frequenzen aufweisen.

7. Verfahren nach einem der Ansprüche 1 bis 6, **dadurch gekennzeichnet, daß** aus einem Wert eines Ausgangssignals (IS) der digitalen polynomischen Regelung des Typs RST und aus mindestens einer Korrespondenztabelle (LUT) der Verstärkungsfaktor-Steuerbefehl (CG$_1$, CG$_2$) und der Polarisationsstrom-Steuerbefehl (CCP$_1$, CCP$_2$) jedes einstellbaren Anfangsverstärkers (PA$_2$, PA$_1$) ausgearbeitet werden.

8. Verstärkersystem mit Leistungsregelung des Ausgangssignals, das mindestens einen einstellbaren Anfangsverstärker (PA$_2$, PA$_1$) aufweist und ein eintreffendes Signal (S) empfängt, **dadurch gekenn-** zeichnet, daß es aufweist:

- erste Ausarbeitungseinrichtungen zum Ausarbeiten einer gefilterten digitalen Information (IP), die die Leistung des Ausgangssignals repräsentiert;
- ein zu folgendes Modell (MOD), das einen Sollwert (CP) empfängt, der eine gewünschte Leistung für das Ausgangssignal repräsentiert, eine gewünschte Übertragungsfunktion für den Aufbau der Leistung in einer gewünschten Antwortzeit hat und eine Steuerinformation (IC) ausgibt; und
- Steuereinrichtungen (3), die einen polynomischen digitalen Regler des Typs RST (4) aufweisen und in der Lage sind, aus der gefilterten digitalen Information (IP) und der Steuerinformation (IC) einen Verstärkungsfaktor-Steuerbefehl (CG$_1$, CG$_2$) und einen Polarisationsstrom-Steuerbefehl (CCP$_1$, CCP$_2$) für jeden einstellbaren Anfangsverstärker (PA$_2$, PA$_1$) auszuarbeiten, wobei die Koeffizienten der Polynome des Reglers (4) von Eingangsparametern abhängen, die Kenndaten jedes einstellbaren Verstärkers (PA$_2$, PA$_1$, PA) und Kenndaten des Filters der ersten Ausarbeitungseinrichtungen aufweisen.

9. System nach Anspruch 8, **dadurch gekennzeichnet, daß** das eintreffende Signal ein Signal ist, das mit einer Modulation mit einer variablen Einhüllenden moduliert ist.

10. System nach Anspruch 8 oder 9, **dadurch gekennzeichnet, daß** der polynomische digitale Regler des Typs RST (4) drei digitale Filter mit endlicher Impulsantwort, ein die gefilterte digitale Information (IP) empfangendes Filter R (4a), ein die Steuerinformation (IC) empfangendes Filter T (4c) und das ein Ausgangssignal (IS) ausgebende Filter 1/S (4b) aufweist.

11. System nach einem der Ansprüche 8 bis 10, **dadurch gekennzeichnet, daß** es ferner einen einstellbaren Ausgangsverstärker (PA), der am Ausgang des letzten einstellbaren Anfangsverstärkers angeschlossen ist, eine Zerhacker-Versorgung (DC/DC) und einen Digital/Analog-Wandler (N/A) aufweist, die in der Lage sind, aus dem Sollwert (CP) einen Verstärkungsfaktor-Steuerbefehl (CG) und einen Polarisationsstrom-Steuerbefehl (CCP) für den einstellbaren Ausgangsverstärker (PA) auszuarbeiten, ohne den polynomischen digitalen Regler des Typs RST (4) zu durchlaufen.

12. System nach einem der Ansprüche 8 bis 11, **dadurch gekennzeichnet, daß** die ersten Ausarbeitungseinrichtungen aufweisen:

- Einrichtungen zum Abgreifen (2) einer Abbildung der elektrischen Ausgangsspannung des Systems;
- ein vor den Abgreifeinrichtungen (2) angeschlossenes Filter (DET); und
- Einrichtungen zur Analog/Digital-Wandlung, die vor dem Filter angeschlossen sind und die gefilterte digitale Information (IP) ausgeben.

13. System nach einem der Ansprüche 8 bis 12, **dadurch gekennzeichnet, daß** es ferner mindestens eine Einrichtung zur Frequenzumsetzung ($MEL_1$, $MEL_{2a}$, $MEL_{2b}$) aufweist, wobei die Steuereinrichtungen (3) in der Lage sind, einen Polarisationsstrom-Steuerbefehl ($CCP'_1$, $CCP'_{2a}$, $CCP'_{2b}$) und gegebenenfalls einen Verstärkungsfaktor-Steuerbefehl ($CG'_1$, $CG'_{2a}$, $CG'_{2b}$) für jede Frequenzumsetzungseinrichtung ($MEL_1$, $MEL_{2a}$, $MEL_{2b}$) auszuarbeiten.

14. System nach einem der Ansprüche 8 bis 13, **dadurch gekennzeichnet, daß** das zu folgende Modell (MOD) ein Filter mit einer gewählten Übertragungsfunktion ist.

15. System nach einem der Ansprüche 8 bis 14, **dadurch gekennzeichnet, daß** die Eingangsparameter Antwortzeiten und die Ordnungen der Übertragungsfunktionen jedes einstellbaren Verstärkers ($PA_2$, $PA_1$, PA), die Zeitkonstante des Ausarbeitungsfilters der gefilterten digitalen Information (IP) und ein Band von zurückzuweisenden Frequenzen aufweisen.

16. System nach einem der Ansprüche 8 bis 15, **dadurch gekennzeichnet, daß** die Steuereinrichtungen ferner mindestens eine Korrespondenztabelle (LUT) zum Bestimmen der Verstärkungsfaktor-Steuerbefehle ($CG_1$, $CG_2$) und der Polarisationsstrom-Steuerbefehle ($CCP_1$, $CCP_2$) aus dem Ausgangssignal (IS) des polynomischen digitalen Reglers des Typs RST (4) aufweisen.

17. Drahtloses Kommunikationsgerät, beispielsweise zellulares Mobiltelefon, das eine Sendekette aufweist mit einem System nach einem der Ansprüche 8 bis 16.

# FIG.1

## FIG.2

Signal sortie système

Temps

FIG.3

Signal sortie détecteur

Temps

## FIG.4

## FIG.5

FIG.6

**EP 1 585 217 B1**

**RÉFÉRENCES CITÉES DANS LA DESCRIPTION**

**Documents brevets cités dans la description**

- EP 0813294 A
- DE 10100151 A
- US 5732334 A
- EP 0889583 A